(19) Europäisches Patentamt
European Patent Office
Office européen des brevets

(11) **EP 2 204 797 B1**

(12) **EUROPEAN PATENT SPECIFICATION**

(45) Date of publication and mention
of the grant of the patent:
**14.12.2011 Bulletin 2011/50**

(51) Int Cl.:
**G10L 19/06** *(2006.01)*

(21) Application number: **09180886.5**

(22) Date of filing: **29.12.2009**

(54) **Signal compression method and apparatus**

Signalkomprimierungsverfahren und -vorrichtung

Procédé de compression de signal et appareil

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **30.12.2008 CN 200810247024**
**25.06.2009 CN 200910149823**

(43) Date of publication of application:
**07.07.2010 Bulletin 2010/27**

(73) Proprietor: **Huawei Technologies Co., Ltd.**
**Longgang District, Shenzhen**
**Guangdong 518129 (CN)**

(72) Inventors:
• **Qi, Fengyan**
**Shenzhen Guangdong 518129 (CN)**
• **Miao, Lei**
**Shenzhen Guangdong 518129 (CN)**
• **Xu, Jianfeng**
**Shenzhen Guangdong 518129 (CN)**
• **Zhang, Dejun**
**Shenzhen Guangdong 518129 (CN)**
• **Zhang, Qing**
**Shenzhen Guangdong 51829 (CN)**
• **Taddei, Herve Marcel**
**80992 Munich (DE)**

(74) Representative: **Barth, Stephan Manuel**
**Reinhard, Skuhra, Weise & Partner GbR**
**Patent- und Rechtsanwälte**
**Friedrichstrasse 31**
**80801 München (DE)**

(56) References cited:
• **KABAL P ED - INSTITUTE OF ELECTRICAL AND ELECTRONICS ENGINEERS: "Ill-conditioning and bandwidth expansion in linear prediction of speech" PROCEEDINGS OF INTERNATIONAL CONFERENCE ON ACOUSTICS, SPEECH AND SIGNAL PROCESSING (ICASSP'03) 6-10 APRIL 2003 HONG KONG, CHINA; [IEEE INTERNATIONAL CONFERENCE ON ACOUSTICS, SPEECH, AND SIGNAL PROCESSING (ICASSP)], 2003 IEEE INTERNATIONAL CONFERENCE, 1 April 2003 (2003-04-01), pages I-824, XP002378183 ISBN: 978-0-7803-7663-2**
• **BACKSTROM T ET AL: "Effect of White-Noise Correction on Linear Predictive Coding" IEEE SIGNAL PROCESSING LETTERS, IEEE SERVICE CENTER, PISCATAWAY, NJ, US LNKD- DOI: 10.1109/LSP.2006.881513, vol. 14, no. 2, 1 February 2007 (2007-02-01), pages 148-151, XP011183762 ISSN: 1070-9908**

**Description**

**Field of the Invention**

The present invention relates to audio compression, and in particular, to a signal compression method and apparatus.

**Background of the Invention**

To save the bandwidth for transmitting and storing speech and audio signals, the speech and audio coding technologies are applied widely. Currently, these coding technologies are mainly classified into lossy coding and lossless coding technologies.

Linear prediction (LP) analysis is widely applied in lossless compression coding to reduce the dynamic range of input signals and to remove the redundancy of the near sample points of signals, but bandwidth expansion is not generally applied in lossless coding.

In G.729 which is a lossy coding, a bandwidth expansion technology is applied by multiplying the autocorrelation coefficients with a lag-window. A 60 Hz bandwidth expansion is performed before calculating the LP coefficients by a Levinson-Durbin algorithm, with a view to making the LP analysis more stable. The steps of calculating the LP coefficients in the prior art are as follows:

> 1. Multiply input signals by a window function, and calculate the autocorrelation coefficients: r(0), r(1)... r(p), where p is the order of LP.
> 2. Calculate the weighting factor $win_{lag}$ of the autocorrelation coefficients:

$$win_{lag}(k) = \exp\left[-\frac{1}{2}\left(\frac{2\pi f_0 k}{f_s}\right)^2\right] \qquad k = 1,\ldots,p$$
,

> where $f_0$ is a constant such as $f_0 = 60Hz$ ; $f_s$ is a signal sampling frequency such as 8000 Hz; and $p$ is the order (such as 10) of LP analysis.
> 3. Determine that the white-noise correction factor is $win_{lag}(0) = 1.0001$.
> 4. Calculate the adjusted autocorrelation coefficients:

$$r(0)' = win_{lag}(0)r(0)$$

$$r(k)' = win_{lag}(k)r(k) \qquad k = 1,\ldots,p$$

> 5. Use the adjusted autocorrelation coefficients to calculate the new LP coefficients through a Levinson-Durbin algorithm.

In the prior art, every frame signal is processed in the same way.

LP analysis is widely applied in lossless coding to reduce the dynamic range of input signals and to remove the redundancy of the near sample points of signals.

In the process of implementing the present invention, the inventor finds at least these defects in the prior art: Because all signals are processed in the same way, ill-conditioned case may occur for some special input signals, and the solving of the autocorrelation matrix is instable, which leads to low compression efficiency of a lossless coder and low quality of reconstructed speech signals of a lossy coder.

**Summary of the Invention**

Embodiments of the present invention provide a signal compression method and apparatus so that different signals are processed differently according to the signal characteristics, thereby avoiding ill-conditioned case generated by special input signals and improving the audio compression efficiency and the quality of reconstructed speech signals.

A signal compression method includes:

multiplying an input signal by a window function;
calculating original autocorrelation coefficients of a windowed input signal;
adjusting autocorrelation coefficient correction factors according to the original autocorrelation coefficients;
calculating modified autocorrelation coefficients according to the original autocorrelation coefficients and the adjusted autocorrelation coefficient correction factors;
calculating linear prediction coefficients according to the modified autocorrelation coefficients; and
coding the input signal according to the linear prediction coefficients, and outputting a coded bit stream.

Another signal compression method includes:

multiplying an input signal by a window function;
calculating original autocorrelation coefficients of a windowed input signal;
calculating an energy parameter according to the first coefficient of the original autocorrelation coefficients, and adjusting a white-noise correction factor according to the energy parameter;
calculating a lag-window according to an expansion bandwidth;
calculating modified autocorrelation coefficients according to the original autocorrelation coefficients, an adjusted white-noise correction factor, and the lag-window;
calculating linear prediction coefficients according to the modified autocorrelation coefficients; and
performing linear prediction for the input signal according to the linear prediction coefficients, calculating a residual signal, coding the residual signal, and outputting a coded bit stream.

A signal compression apparatus includes:

a windowing unit, configured to multiply an input signal by a window function;
an original autocorrelation coefficients calculating unit, configured to calculate the original autocorrelation coefficients of an input signal processed by the windowing unit;
a bandwidth expanding unit, configured to adjust autocorrelation coefficient correction factors according to the original autocorrelation coefficients calculated by the original autocorrelation coefficients calculating unit, and calculate modified autocorrelation coefficients according to the original autocorrelation coefficients and the adjusted autocorrelation coefficient correction factors;
a linear prediction coefficients calculating unit, configured to calculate the linear prediction coefficients according to the modified autocorrelation coefficients calculated by the bandwidth expanding unit; and
a compressing unit, configured to code the input signal according to the linear prediction coefficients calculated by the linear prediction coefficients calculating unit, and output a coded bit stream.

In the technical solution under embodiments of the present invention, the autocorrelation coefficient correction factors are adjusted according to the original autocorrelation coefficients so that the adjusted autocorrelation coefficient correction factors can express the difference of input signals, thereby avoiding ill-conditioned cases of special input signals, making the modified autocorrelation coefficients more suitable for subsequent compression processing, improving the compression efficiency of a lossless coder and the quality of reconstructed speech signals of a lossy coder, and involving only simple operations.

## Brief Description of the Drawings

The accompanying drawings are intended for better understanding of the present invention and constitute part of this application rather than a limitation on the present invention.

FIG. 1 is a flowchart of a signal compression method in the first embodiment of the present invention;
FIG. 2 is a flowchart of a signal compression method in the second embodiment of the present invention;
FIG. 3 is a flowchart of a signal compression method in the third embodiment of the present invention;
FIG. 4 is a flowchart of a signal compression method in the fourth embodiment of the present invention;
FIG. 5 shows a structure of a signal compression apparatus in the fifth embodiment of the present invention;
FIG. 6 shows a structure of a signal compression apparatus in the sixth embodiment of the present invention;
FIG. 7 shows a structure of a bandwidth expanding unit of a signal compression apparatus in the sixth embodiment of the present invention;
FIG. 8 shows a structure of a signal compression apparatus in the seventh embodiment of the present invention;
FIG. 9 shows a structure of a bandwidth expanding unit of a signal compression apparatus in the seventh embodiment of the present invention; and
FIG. 10 shows another structure of a bandwidth expanding unit in the sixth or seventh embodiment of the present invention.

## Detailed Description of the Invention

To make the technical solution, objectives and merits of the present invention clear, the following describes the present invention in detail with reference to the accompanying drawings and exemplary embodiments. The exemplary embodiments of the present invention and the description thereof are intended for interpreting rather than limiting the present invention.

The embodiments of the present invention provide a signal compression method and apparatus. The embodiments of the present invention are detailed below with reference to the accompanying drawings.

### First Embodiment

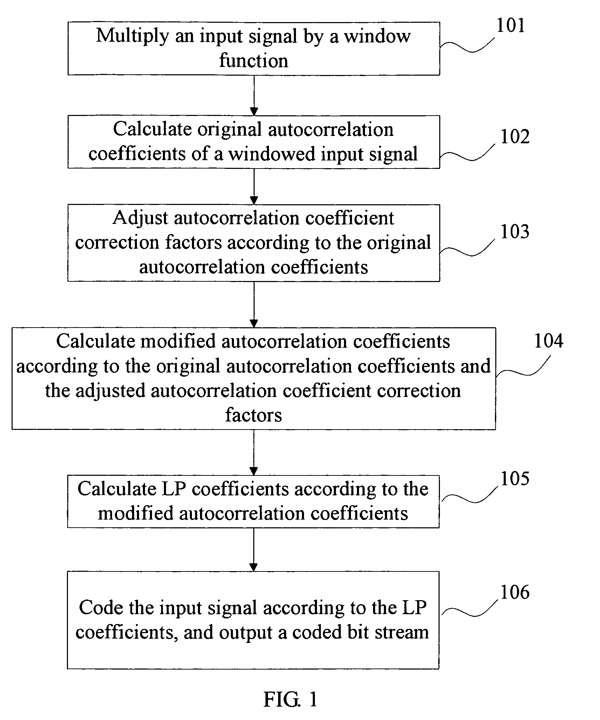

FIG. 1 is a flowchart of a signal compression method in the first embodiment of the present invention. The method includes the following steps:

Step 101: Multiply an input signal by a window function.
Step 102: Calculate original autocorrelation coefficients of a windowed input signal.
Step 103: Adjust autocorrelation coefficient correction factors according to the original autocorrelation coefficients.
Step 104: Calculate modified autocorrelation coefficients according to the original autocorrelation coefficients and the adjusted autocorrelation coefficient correction factors.

The autocorrelation coefficient correction factors include a white-noise correction factor and a lag-window. Adjusting the autocorrelation coefficient correction factors may be: adjusting the white-noise correction factor and the lag-window, or adjusting the white-noise correction factor only, or adjusting the lag-window only.

Adjusting the autocorrelation coefficient correction factors according to the original autocorrelation coefficients may be: determining characteristic parameters of the input signal according to the original autocorrelation coefficients and adjusting the autocorrelation coefficient correction factors according to the characteristic parameters. The characteristic parameters may be: energy, periodicity parameter, zero crossing rate, or reflection coefficient, or any combination thereof; and may be extracted from original input signals or signals obtained in any step.

Step 105: Calculate LP coefficients according to the modified autocorrelation coefficients.

Step 106: Code the input signal according to the LP coefficients, and output a coded bit stream.

Coding the input signal according to the LP coefficients may be: performing LP analysis for the input signal according to the LP coefficients, calculating a residual signal, and then performing Long Term Prediction (LTP) and entropy coding, and finally, outputting a lossless coded bit stream of the residual signal; or, inputting the LP coefficients and the input signal into the Code Excited Linear Prediction (CELP) model to obtain the bit stream.

In another embodiment of the present invention, a preprocessing step may be included. Before step 101, the input signal is preprocessed. For lossy compression, the preprocessing may be a pre-emphasis filtering or a high-pass filtering for increasing the high-frequency components of the input signal or filtering out unnecessary low-frequency interference components. Afterward, the filtered signal is windowed according to step 101. For lossless compression, the preprocessing may be a mapping operation; that is, the input signal is mapped from the A-law or $\mu$-law to the Pulse Coding Modulation (PCM) domain. The signals in the PCM domain are more suitable for LP short-term prediction.

With the technical solution in the foregoing embodiment, the original autocorrelation coefficients reflect the characteristics of each frame signal; according to such characteristics, the autocorrelation coefficient correction factors are adjusted so that the adjusted autocorrelation coefficient correction factors are determined according to the characteristics of each frame signal. Therefore, the LP coefficients fit in with the characteristics of the signals more accurately; ill-conditioned cases are avoided; the calculated coefficients are more robust; and the calculation complexity is low.

### Second Embodiment

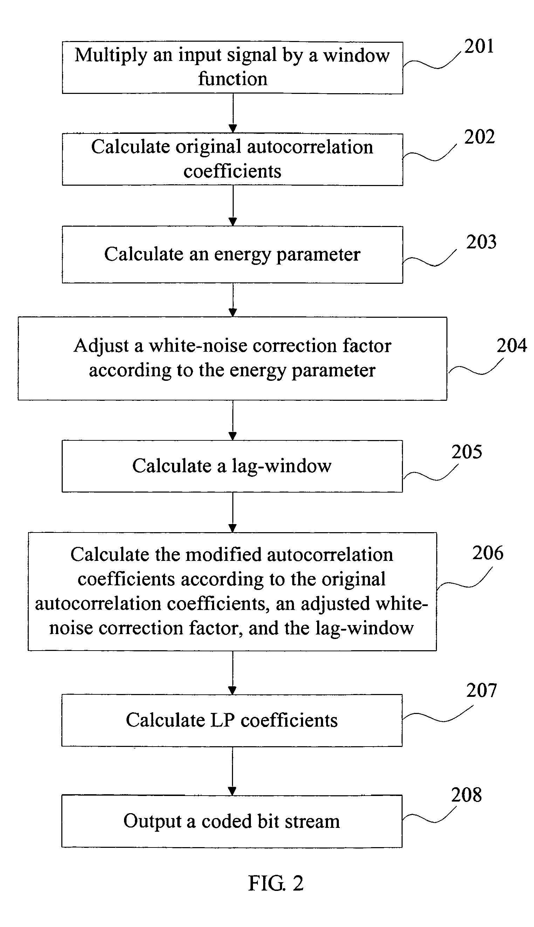

FIG. 2 is a flowchart of a signal compression method in the second embodiment of the present invention. The method includes the following steps:

Step 201: Multiply an input signal by a window function. The window here may be the window applied to lossy coding in the prior art. The input signal $s(n)$ is multiplied by the window function $win(n)$ to obtain a windowed input signal $s'(n)$:

$$s'(n) = win(n)s(n) \qquad n = 0, \dots N - 1,$$

where N is the frame length.

Step 202: Calculate original autocorrelation coefficients $r(k)$ according to the windowed input signal $s'(n)$, for example, through the following formula:

$$r(k) = \sum_{n=k}^{N-1} s'(n)s'(n-k) \qquad k = 0, \dots, p,$$

where $p$ is the order of LP.

Step 203: Calculate an energy parameter $E$ according to the original autocorrelation coefficients.

In some embodiments, the frame average energy may be calculated according to the first coefficient $r(0)$ of the original autocorrelation coefficients:

$$Ener\_avg = r(0)/N,$$

where N is the frame length.

In other embodiments, the frame energy parameter may be calculated according to the first coefficient $r(0)$ of the original autocorrelation coefficients:

$$Ener = 30 - \lfloor \log_2[r(0)] \rfloor,$$

where $\lfloor x \rfloor$ refers to rounding down, namely, $\lfloor x \rfloor = \max\{ n \in \{\dots, -2, -1, 0, 1, 2, \dots\} \,|\, x \geq n \}$.

Step 204: Adjust a white-noise correction factor according to the energy parameter.

In this embodiment, an energy threshold $E_{thr}$ may be set. According to the relationship between the energy parameter $E$ and the $E_{thr}$, the input signals are

$$win_{lag}(0) = \begin{cases} function\_1(r(0)); & E \in [0, E_{thr1}) \\ function\_2(r(0)); & E \in [E_{thr1}, E_{thr2}) \\ \vdots \\ function\_n(r(0)); & E \in [E_{thr(n-1)}, E_{thrn}] \end{cases}$$

In some embodiments, the frame signals are categorized into high-energy frame signals and low-energy frame signals according to the frame average energy $Ener\_avg$ and the energy threshold $E_{thr}$, and then the white-noise correction factor $win_{lag}(0)$ is adjusted accordingly:

$$if(Ener\_avg >= E_{thr})$$
$$win_{lag}(0) = H + \alpha * Ener\_avg;$$
$$else$$
$$win_{lag}(0) = L + \beta * Ener\_avg;$$

The energy threshold $E_{thr}$ is determined as a constant that can differentiate between unvoiced and voiced speech by plenty of speech corpora. For example, $E_{thr}$ = 1638, which is approximately 32 dB. $H$, $L$, $\alpha$, $\beta$ are empirical constants, and may be obtained through training by using representative training data, and the training is benchmarked against the final coder performance. For example, $H$ = 1.001, $L$ = 1.002, $\alpha = \beta = -6 \times 10^{-7}$.

In other embodiments, the frame signals are categorized into high-energy frame signals and low-energy frame signals according to the frame energy parameter $Ener$ and the energy threshold $E_{thr}$, and then the white-noise correction factor $win_{lag}(0)$ is adjusted accordingly:

$$if(Ener < E_{thr})$$
$$win_{lag}(0) = L + \beta * (Ener + E_{thr});$$
$$else$$
$$win_{lag}(0) = H + \alpha * (Ener + E_{thr});$$

The energy threshold $E_{thr}$ is determined as a constant that can differentiate between unvoiced and voiced speech by plenty of speech corpora. Considering the impact from the frame length, different energy thresholds may be set for different frame lengths, for example, $E_{thr} = \begin{cases} 13 & N = 160 \\ 12 & N = 240,320 \end{cases}$ . $H, L, \alpha, \beta$ $H$, $L$, $\alpha$, $\beta$ are empirical constants, and may be obtained through training by using representative training data, and the training is benchmarked against the final coder performance. For example, $H$ = 1.0028, $L$ = 1.0018, $\alpha = \beta = -2^{-14}$.

Step 205: Calculate a lag-window $win_{lag}(k)$ according to an expansion bandwidth $f_0$:

$$win_{lag}(k) = \exp\left[-\frac{1}{2}\left(\frac{2\pi f_0 k}{f_s}\right)^2\right] \qquad k = 1,\ldots,p$$

where $f_0$ is the expansion bandwidth such as 34 Hz; $f_s$ is a signal sampling frequency such as 8000 Hz; and $p$ is the order of LP.

Step 206: According to the original autocorrelation coefficients $r(k)$, an adjusted white-noise correction factor $win_{lag}(0)$ and the lag-window $win_{lag}(k)$, calculate the modified autocorrelation coefficients $r(0)'$ ... $r(k)'$ after the autocorrelation coefficient correction factors are adjusted:

$$r(0)' = win_{lag}(0)r(0)$$

$$r(k)' = win_{lag}(k)r(k) \qquad k = 1,\ldots,p$$

Step 207: Use the modified autocorrelation coefficients $r(0)'$ ... $r(k)'$ to calculate LP coefficients through a Levinson-Durbin algorithm.

Step 208: Code the input signal according to the LP coefficients, and output a coded bit stream. Performing the compression coding for the input signal according to the LP coefficients may be: calculating a residual signal of the input signal through LP analysis, and then performing LTP and entropy coding, and finally, outputting a lossless coded bit stream of the residual signal; or, inputting the LP coefficients and the input signal into the CELP model to obtain a coded bit stream.

With the technical solution in this embodiment, the energy parameter that indicates the characteristics of the input signal is calculated through the original autocorrelation coefficients; according to the energy parameter, the white-noise correction factor is adjusted so that the adjusted autocorrelation coefficient correction factors are determined according to the characteristics of each frame signal. Therefore, the LP coefficients fit in with the characteristics of the signals more accurately; ill-conditioned cases are avoided; the calculated coefficients are more robust; and the calculation complexity is low.

**Third Embodiment**

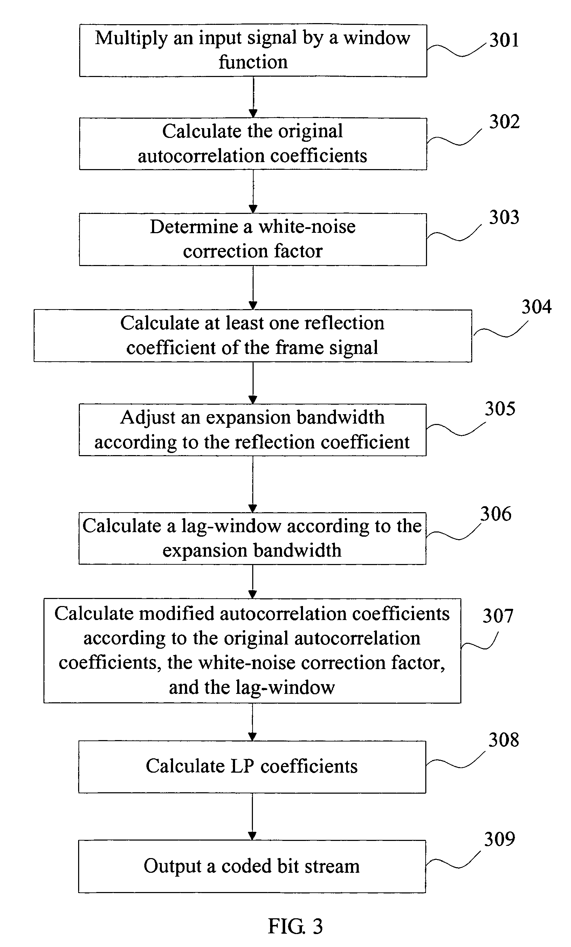

FIG. 3 is a flowchart of a signal compression method in the third embodiment of the present invention. The method includes the following steps:

Step 301: Multiply an input signal by a window function. The window here may be the window applied to lossy coding in the prior art. The input signal $s(n)$ is multiplied by the window function $win(n)$ to obtain a windowed input signal $s'(n)$:

$$s'(n) = win(n)s(n) \qquad n = 0, \ldots N - 1,$$

where $N$ is the frame length.

Step 302: Calculate the original autocorrelation coefficients $r(k)$ according to the windowed input signal $s'(n)$, for example, through the following formula:

$$r(k) = \sum_{n=k}^{N-1} s'(n)s'(n-k) \qquad k = 0, \ldots, p,$$

where $p$ is the order of LP.

Step 303: Determine a white-noise correction factor to be $win_{lag}(0) = 1.0001$.

Step 304: Calculate at least one reflection coefficient of the windowed input signal according to the original autocorrelation coefficients. In this embodiment, only the first reflection coefficient is calculated to simplify the calculation, but the present invention is not limited to calculate only the first reflection coefficient. The reflection coefficient may be calculated through the Levinson-Durbin recursive algorithm:

$$E^{[0]} = r(0)$$
$$for\ i = 1\ to\ p$$
$$a_0^{[i-1]} = 1$$
$$k_i' = -\left[\sum_{j=0}^{i-1} a_j^{[i-1]} r(i-j)\right] / E^{[i-1]}$$
$$a_i^{[i]} = k_i'$$
$$for\ j = 1\ to\ i-1$$
$$a_j^{[i]} = a_j^{[i-1]} + k_i' a_{i-j}^{[i-1]}$$
$$end$$
$$E^{[i]} = (1 - k_i'^2) E^{[i-1]}$$
$$end$$

Through this recursive algorithm, the $k_i = -k'_i\ i = 1,..., p$ is calculated, where:

$$k_1 = {r(1)}\big/{r(0)}.$$

Step 305: According to the at least one reflection coefficient, for example $k_1$, adaptively calculate and adjust an expansion bandwidth $f_0$:

$f_0 = F + \alpha k_1$, where F may be a constant such as 60 Hz, and $\alpha$ is a regulating expansion factor which may be obtained through the training by using representative training data, where the training is benchmarked against the final coder performance. For example, $\alpha = 10$.

Step 306: Calculate a lag-window according to the expansion bandwidth $f_0$:

$$win_{lag}(k) = \exp\left[-\frac{1}{2}\left(\frac{2\pi f_0 k}{f_s}\right)^2\right] \qquad k = 1,...,p$$

where $f_0$ is the expansion bandwidth calculated in step 305; $f_s$ is a signal sampling frequency such as 8000 Hz; and $p$ is the order of LP.

Step 307: According to the original autocorrelation coefficients $r(k)$, the white-noise correction factor $win_{lag}(0)$ and the lag-window $win_{lag}(k)$, calculate modified autocorrelation coefficients $r(0)'$ ... $r(k)'$ after the autocorrelation coefficient correction factors are adjusted:

$$r(0)' = win_{lag}(0)r(0)$$

$$r(k)' = win_{lag}(k)r(k) \qquad k = 1,...,p$$

Step 308: Use the modified autocorrelation coefficients $r(0)'$ ... $r(k)'$ to calculate LP coefficients through a Levinson-Durbin algorithm.

Step 309: Code the input signal according to the LP coefficients, and output a coded bit stream. Coding the input signal according to the LP coefficients may be: inputting the LP coefficients and the input signal into the CELP model to obtain a coded bit stream; or, calculating a residual signal of the input signal through LP analysis, and then performing LTP and entropy coding, and finally, outputting a lossless coded bit stream of the residual signal.

With the technical solution in this embodiment, the reflection coefficient that indicates the characteristics of the input signal is calculated through the original autocorrelation coefficients; according to the reflection coefficient, the expansion bandwidth is determined, and the lag-window is adjusted so that the adjusted autocorrelation coefficient correction factors are determined according to the characteristics of each frame signal. Therefore, the LP coefficients fit in with the characteristics of the signals more accurately; ill-conditioned cases are avoided; the calculated coefficients are more robust; and the calculation complexity is low.

**Fourth Embodiment**

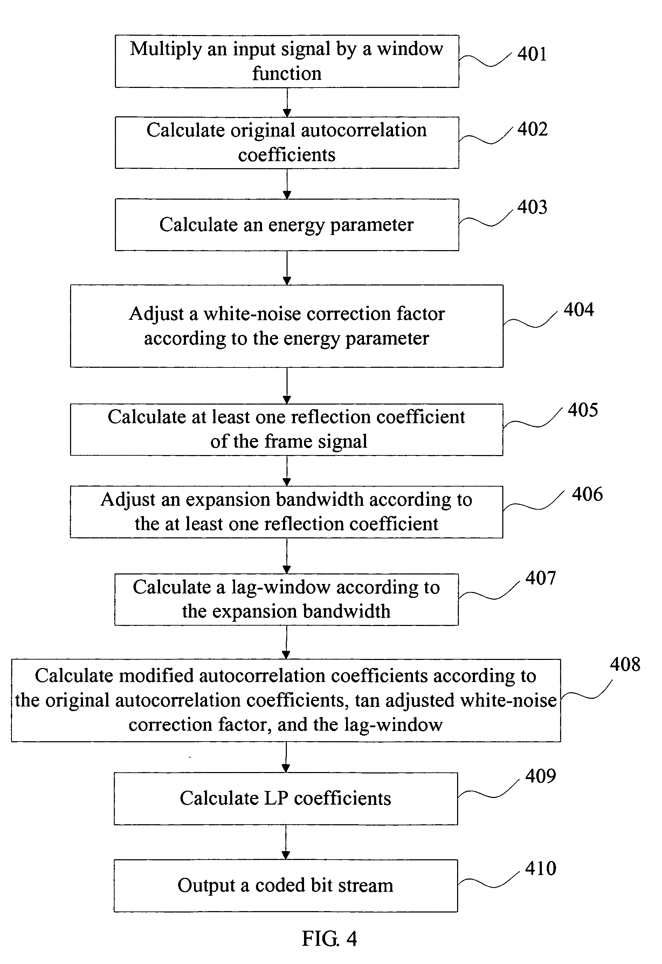

FIG. 4 is a flowchart of a signal compression method in the fourth embodiment of the present invention. The method includes the following steps:

Step 401: Multiply an input signal by a window function. The window here may be the window applied to lossy coding in the prior art. The input signal $s(n)$ is multiplied by the window function $win(n)$ to obtain a windowed input signal $s'(n)$:

$$s'(n) = win(n)s(n) \qquad n = 0, \ldots N - 1,$$

where $N$ is the frame length.

Step 402: Calculate original autocorrelation coefficients $r(k)$ according to the windowed input signal $s'(n)$, for example, through the following formula:

$$r(k) = \sum_{n=k}^{N-1} s'(n)s'(n-k) \qquad k = 0, \ldots, p,$$

where $p$ is the order of LP.

Step 403: Calculate an energy parameter according to the original autocorrelation coefficients.

In some embodiments, the frame average energy may be calculated according to the first coefficient $r(0)$ of the original autocorrelation coefficients:

$$Ener\_avg = r(0)/N,$$

where N is the frame length.

In other embodiments, the frame energy parameter may be calculated according to the first coefficient $r(0)$ of the original autocorrelation coefficients:

$$Ener = 30 - \lfloor \log_2[r(0)] \rfloor,$$

where $\lfloor x \rfloor$ refers to rounding down, namely, $\lfloor x \rfloor = \max\{n \in \{\ldots, -2, -1, 0, 1, 2, \ldots\} \mid x \geq n\}$.

Step 404: Adjust a white-noise correction factor according to the energy parameter.

In this embodiment, an energy threshold $E_{thr}$ may be set. According to the relationship between the energy parameter $E$ and the $E_{thr}$, the input signals are differentiated. Different adjustment functions are used to adjust the white-noise correction factor for different input signals. Specifically, different adjustment functions are used to adjust the white-noise correction factor according to different energy threshold intervals that in which the energy parameter ranges:

$$win_{lag}(0) = \begin{cases} function\_1(r(0)); & E \in [0, E_{thr1}) \\ function\_2(r(0)); & E \in [E_{thr1}, E_{thr2}) \\ \vdots \\ function\_n(r(0)); & E \in [E_{thr(n-1)}, E_{thrn}] \end{cases}$$

In some embodiments, the frame signals are categorized into high-energy frame signals and low-energy frame signals according to the frame average energy $Ener\_avg$ and the energy threshold $E_{thr}$, and then the white-noise correction factor $win_{lag}(0)$ is adjusted accordingly:

$$if(Ener\_avg >= E_{thr})$$
$$win_{lag}(0) = H + \alpha * Ener\_avg;$$
$$else$$
$$win_{lag}(0) = L + \beta * Ener\_avg;$$

where $E_{thr}$, $H$, $L$, $\alpha$, $\beta$ are empirical constants, which may be obtained according to the specific conditions.

In other embodiments, the frame signals are categorized into high-energy frame signals and low-energy frame signals according to the frame energy parameter $Ener$ and the energy threshold $E_{thr}$, and then the white-noise correction factor $win_{lag}(0)$ is adjusted accordingly:

$$if(Ener < E_{thr})$$
$$win_{lag}(0) = L + \beta * (Ener + E_{thr});$$
$$else$$
$$win_{lag}(0) = H + \alpha * (Ener + E_{thr});$$

where $E_{thr}$, $H$, $L$, $\alpha$, $\beta$ are empirical constants that may be obtained according to the specific conditions.

Step 405: Calculate at least one reflection coefficient of the windowed input signal according to the original autocorrelation coefficients. In this embodiment, only the first reflection coefficient is calculated to simplify the calculation, but the present invention is not limited to calculate only the first reflection coefficient.

$$k_1 = \frac{r(1)}{r(0)}.$$

Step 406: According to the at least one reflection coefficient, for example $k_1$, adaptively calculate and adjust an expansion bandwidth $f_0$:

$f_0 = F + \alpha k_1$, where F may be a constant such as 60 Hz, and $\alpha$ is a regulating expansion factor which may be obtained through training by using representative training data, and the training is benchmarked against the final coder performance. For example, $\alpha = 10$.

Step 407: Calculate a lag-window according to the expansion bandwidth $f_0$:

$$win_{lag}(k) = \exp\left[-\frac{1}{2}\left(\frac{2\pi f_0 k}{f_s}\right)^2\right] \qquad k = 1, \ldots, p$$

where $f_0$ is the expansion bandwidth calculated in step 406; $f_s$ is a signal sampling frequency such as 8000 Hz; and $p$ is the order of LP.

Step 408: According to the original autocorrelation coefficients $r(k)$, an adjusted white-noise correction factor $win_{lag}(0)$ and the lag-window $win_{lag}(k)$, calculate modified autocorrelation coefficients after the autocorrelation coefficient correction factors are adjusted:

$$r(0)' = win_{lag}(0)r(0)$$

$$r(k)' = win_{lag}(k)r(k) \qquad k = 1, \ldots, p$$

Step 409: Use the modified autocorrelation coefficients $r(0)'$ ... $r(k)'$ to calculate LP coefficients through a Levinson-Durbin algorithm.

Step 410: Code the input signal according to the LP coefficients, and output a coded bit stream. Coding the input signal according to the LP coefficients may be: calculating a residual signal of the input signal through LP analysis, and then performing LTP and entropy coding, and finally, outputting a lossless coded bit stream of the residual signal; or, inputting the LP coefficients and the input signal into the CELP model to obtain a coded bit stream.

With the technical solution in this embodiment, the energy parameter and the reflection coefficient that indicates the characteristics of the input signal are calculated through the original autocorrelation coefficients; according to the energy parameter, the white-noise correction factor is adjusted; according to the reflection coefficient, the expansion bandwidth is determined, and the lag-window is adjusted so that the adjusted autocorrelation coefficient correction factors are determined according to the characteristics of each frame signal. Therefore, the LP coefficients fit in with the characteristics of the signals more accurately; ill-conditioned cases are avoided; the calculated coefficients are more robust; and the calculation complexity is low.

**Fifth Embodiment**

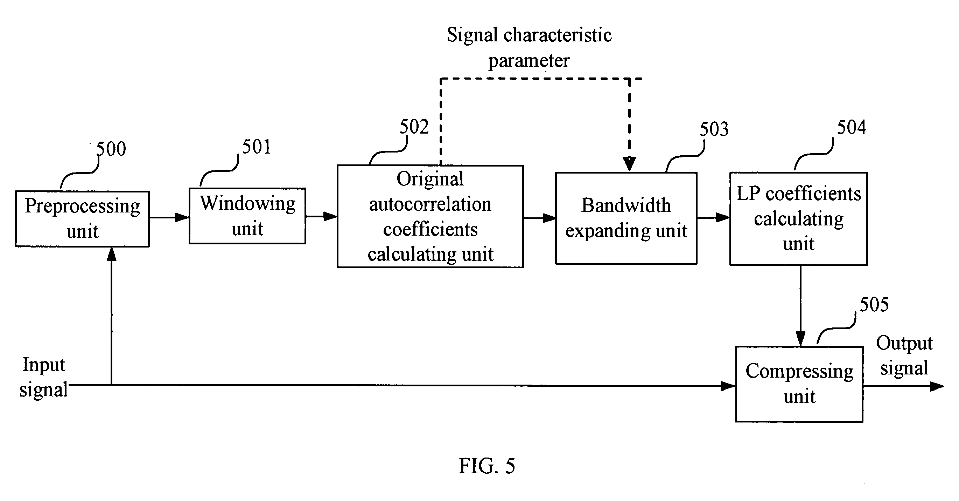

FIG. 5 shows a structure of a signal compression apparatus in the fifth embodiment of the present invention. The apparatus includes:

a windowing unit 501, configured to multiply an input signal by a window function;
an original autocorrelation coefficients calculating unit 502, configured to calculate the original autocorrelation coefficients of an input signal processed by the windowing unit 501;
a bandwidth expanding unit 503, configured to adjust autocorrelation coefficient correction factors according to the original autocorrelation coefficients calculated by the original autocorrelation coefficients calculating unit 502, and calculate modified autocorrelation coefficients according to the original autocorrelation coefficients and the adjusted autocorrelation coefficient correction factors;
a linear prediction coefficients calculating unit 504, configured to calculate the LP coefficients according to the modified autocorrelation coefficients calculated by the bandwidth expanding unit 503; and
a compressing unit 505, configured to code the input signal according to the LP coefficients calculated by the linear prediction coefficients calculating unit 504, and output a coded bit stream.

In another embodiment of the present invention, the apparatus may further include a preprocessing unit 500, which is configured to preprocess the input signal for different types of compression, and send a preprocessed input signal to the windowing unit 501 to make the input signal more suitable for being processed by subsequent modules. For lossy compression, the preprocessing unit may be a pre-emphasis filtering or a high-pass filter which is configured to increase the high-frequency components of the input signal or to filter out unnecessary low-frequency interference components. Afterward, the filtered signal is input into the windowing unit 501. For lossless compression, the preprocessing unit may be a mapping module which maps the input signal from the A-law or μ-law to the PCM domain. The signals in the PCM domain are more suitable for LP short-term prediction.

With the technical solution in the foregoing embodiment, the original autocorrelation coefficients reflect the characteristics of each frame signal; according to such characteristics, the autocorrelation coefficient correction factors are adjusted so that the adjusted autocorrelation coefficient correction factors are determined according to the characteristics of each frame signal. Therefore, the LP coefficients fit in with the characteristics of the signals more accurately; ill-conditioned cases are avoided; the calculated coefficients are more robust; and the calculation complexity is low.

**Sixth Embodiment**

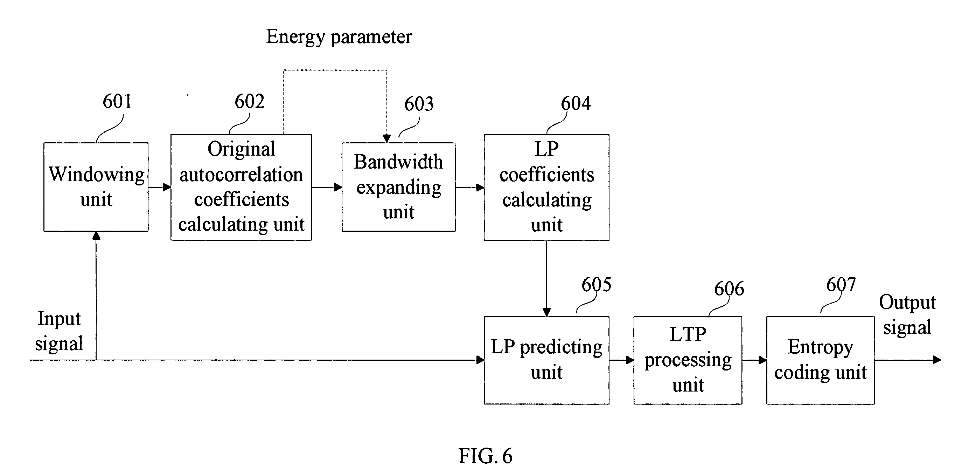

FIG. 6 shows a structure of a signal compression apparatus in the sixth embodiment of the present invention. The apparatus includes: a windowing unit 601, an original autocorrelation coefficients calculating unit 602, a bandwidth expanding unit 603, an LP coefficients calculating unit 604, an LP predicting unit 605, an LTP processing unit 606, and an entropy coding unit 607.

The windowing unit 601 is configured to multiply an input signal by a window function. The windowing unit 601 may be a windowing unit applied to lossy coding in the prior art. The input signal $s(n)$ is multiplied by the window function $win(n)$ to obtain a windowed input signal $s'(n)$:

$$s'(n) = win(n)s(n) \qquad n = 0, \ldots N-1,$$

where N is the frame length.

The original autocorrelation coefficients calculating unit 602 is configured to calculate the original autocorrelation coefficients of an input signal processed by the windowing unit 601, for example, through the following formula:

$$r(k) = \sum_{n=k}^{N-1} s'(n)s'(n-k) \qquad k = 0, \ldots, p,$$

where $p$ is the order of LP.

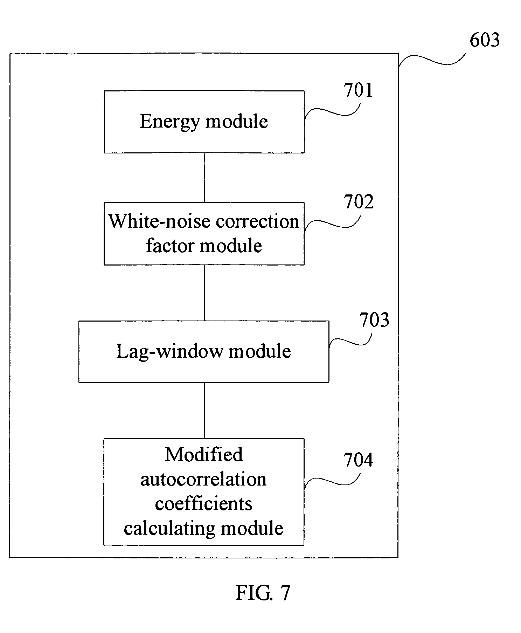

As shown in FIG. 7, the bandwidth expanding unit 603 may include an energy module 701, a white-noise correction factor module 702, a lag-window module 703, and a modified autocorrelation coefficients calculating module 704.

The energy module 701 is configured to calculate an energy parameter according to the original autocorrelation coefficients.

In some embodiments, the energy module 701 may calculate the frame average energy according to the first coefficient $r(0)$ of the original autocorrelation coefficients:

$$Ener\_avg = r(0)/N,$$

where N is the frame length.

In other embodiments, the energy module 701 may calculate the frame energy parameter $Ener$ according to the first coefficient $r(0)$ of the original autocorrelation coefficients:

$$Ener = 30 - \lfloor \log_2[r(0)] \rfloor,$$

where $\lfloor x \rfloor$ refers to rounding down, namely, $\lfloor x \rfloor = \max \{ n \in \{ \ldots, -2, -1, 0, 1, 2, \ldots \} \mid x \geq n \}$.

The white-noise correction factor module 702 is configured to adjust the white-noise correction factor according to the energy parameter calculated by the energy module 701.

In this embodiment, an energy threshold $E_{thr}$ may be set. According to the relationship between the energy parameter $E$ and the $E_{thr}$, the input signals are differentiated. Different adjustment functions are used to adjust the white-noise correction factor for different input signals. Specifically, different adjustment functions are used to adjust the white-noise correction factor according to different energy threshold intervals in which the energy parameter ranges:

$$win_{lag}(0) = \begin{cases} function\_1(r(0)); & E \in [0, E_{thr1}) \\ function\_2(r(0)); & E \in [E_{thr1}, E_{thr2}) \\ \vdots & \\ function\_n(r(0)); & E \in [E_{thr(n-1)}, E_{thrn}] \end{cases}$$

In some embodiments, the white-noise correction factor module 702 may categorize the frame signals into high-energy frame signals and low-energy frame signals according to the frame average energy $Ener\_avg$ and the energy threshold $E_{thr}$, and then adjust the white-noise correction factor $win_{lag}(0)$ accordingly:

$$if(Ener\_avg >= E_{thr})$$
$$win_{lag}(0) = H + \alpha * Ener\_avg;$$
$$else$$
$$win_{lag}(0) = L + \beta * Ener\_avg;$$

where $E_{thr}$, $H$, $L$, $\alpha$, $\beta$ are empirical constants, which may be obtained according to the specific conditions.
In other embodiments, the white-noise correction factor module 702 may categorize the frame signals into high-energy frame signals and low-energy frame signals according to the frame energy parameter $Ener$ and the energy threshold $E_{thr}$, and then adjust the white-noise correction factor $win_{lag}(0)$ accordingly:

$$if(Ener < E_{thr})$$
$$win_{lag}(0) = L + \beta * (Ener + E_{thr});$$
$$else$$
$$win_{lag}(0) = H + \alpha * (Ener + E_{thr});$$

where $H$, $L$, $\alpha$, $\beta$ are empirical constants, which may be obtained according to the specific conditions.
The lag-window module 703 is configured to calculate a lag-window $win_{lag}(k)$ according to an expansion bandwidth $f_0$:

$$win_{lag}(k) = \exp\left[-\frac{1}{2}\left(\frac{2\pi f_0 k}{f_s}\right)^2\right] \qquad k = 1, \ldots, p$$
,

where $f_0$ is the expansion bandwidth such as 34 Hz; $f_s$ is a signal sampling frequency such as 8000 Hz; and $p$ is the order of LP.
The modified autocorrelation coefficients calculating module 704 is configured to: according to the original autocorrelation coefficients $r(k)$, an adjusted white-noise correction factor $win_{lag}(0)$ and the lag-window $win_{lag}(k)$, calculate the modified autocorrelation coefficients after the autocorrelation coefficient correction factors are adjusted:

$$r(0)' = win_{lag}(0)r(0)$$

$$r(k)' = win_{lag}(k)r(k) \qquad k = 1,\ldots,p \,'$$

The LP coefficients calculating unit 604 is configured to calculate the LP coefficients through the Levinson-Durbin algorithm according to the modified autocorrelation coefficients $r(0)' \ldots r(k)'$ adjusted by the bandwidth expanding unit 603.

The LP predicting unit 605 is configured to perform LP analysis for the input signal according to the LP coefficients calculated by the LP coefficients calculating unit 604, and calculate a residual signal.

The LTP processing unit 606 is configured to perform LTP for the residual signal output by the LP predicting unit 605.

The entropy coding unit 607 is configured to perform entropy coding for the signal which are output by the LTP processing unit 606 after the long-term prediction, and output the lossless coded bit stream of the residual signal.

The LP predicting unit 605, the LTP processing unit 606, and the entropy coding unit 607 may be the functional units applied in the prior art.

With the technical solution in this embodiment, the energy parameter that indicates the characteristics of the input signal is calculated through the original autocorrelation coefficients; according to the energy parameter, the white-noise correction factor is adjusted so that the adjusted autocorrelation coefficient correction factors are determined according to the characteristics of each frame signal. Therefore, the LP coefficients fit in with the characteristics of the signals more accurately; ill-conditioned cases are avoided; the calculated coefficients are more robust; and the calculation complexity is low.

**Seventh Embodiment**

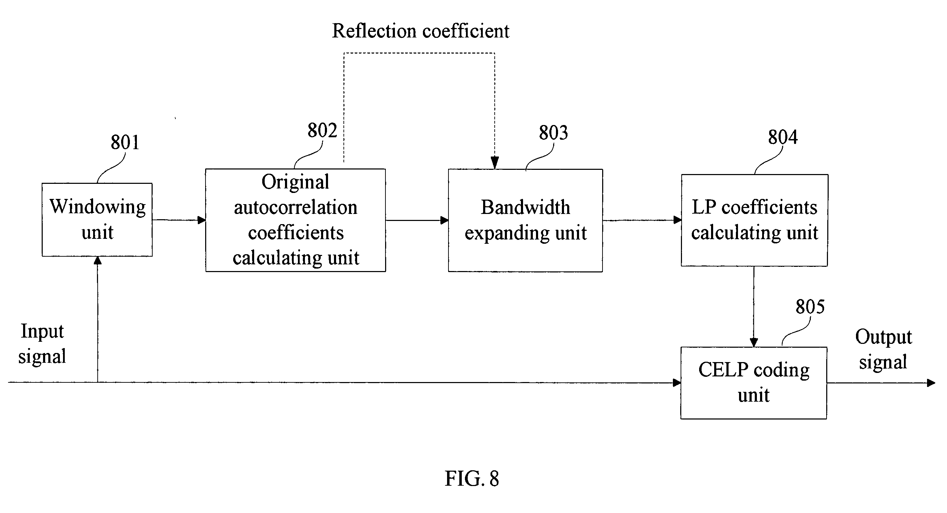

FIG. 8 shows a structure of a signal compression apparatus in the seventh embodiment of the present invention. The apparatus includes: a windowing unit 801, an original autocorrelation coefficients calculating unit 802, a bandwidth expanding unit 803, an LP coefficients calculating unit 804, and a CELP coding unit 805.

The windowing unit 801 is configured to multiply an input signal by a window function. The windowing unit 801 may be a windowing unit applied to lossy coding in the prior art. The input signal $s(n)$ is multiplied by the window function $win(n)$ to obtain a windowed input signal $s'(n)$:

$$s'(n) = win(n)s(n) \qquad n = 0,\ldots N-1,$$

where N is the frame length.

The original autocorrelation coefficients calculating unit 802 is configured to calculate the original autocorrelation coefficients of an input signal processed by the windowing unit 801, for example, through the following formula:

$$r(k) = \sum_{n=k}^{N-1} s'(n)s'(n-k) \qquad k = 0,\ldots,p,$$

where $p$ is the order of LP.

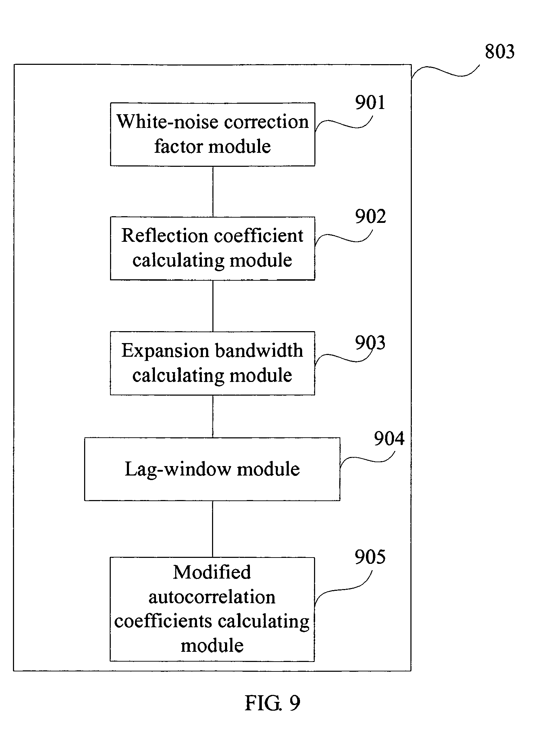

As shown in FIG. 9, the bandwidth expanding unit 803 may include a white-noise correction factor module 901, a reflection coefficient calculating module 902, an expansion bandwidth calculating module 903, a lag-window module 904, and a modified autocorrelation coefficients calculating module 905.

The white-noise correction factor module 901 is configured to determine the white-noise correction factor $win_{lag}$ (0) = 1.0001.

The reflection coefficient calculating module 902 is configured to calculate at least one reflection coefficient of the frame signal according to the original autocorrelation coefficients. In this embodiment, only the first reflection coefficient is calculated to simplify the calculation, but the present invention is not limited to calculate only the first reflection coefficient:

$$k_1 = \frac{r(1)}{r(0)} \cdot$$

The expansion bandwidth calculating module 903 is configured to adaptively calculate and adjust the expansion bandwidth according to the reflection coefficient $k_1$ calculated by the reflection coefficient calculating module 902:

$f_0 = F + \alpha k_1$, where F may be 60 Hz, and $\alpha$ is an empirical factor which is determined experimentally.

The lag-window module 904 is configured to calculate the lag-window according to the expansion bandwidth $f_0$ output by the expansion bandwidth calculating module 903:

$$win_{lag}(k) = \exp\left[ -\frac{1}{2}\left( \frac{2\pi f_0 k}{f_s} \right)^2 \right] \qquad k = 1, \dots, p$$

where $f_0$ is the expansion bandwidth calculated by the expansion bandwidth calculating module 903; $f_s$ is a signal sampling frequency such as 8000 Hz; and $p$ is the order of LP.

The modified autocorrelation coefficients calculating module 905 is configured to: according to the original autocorrelation *coefficients* $r(k)$, the white-noise correction factor $win_{lag}(0)$ and the lag-window $win_{lag}(k)$, calculate the modified autocorrelation coefficients after the autocorrelation coefficient correction factors are adjusted:

$$r(0)' = win_{lag}(0)r(0)$$

$$r(k)' = win_{lag}(k)r(k) \cdot \qquad k = 1, \dots, p$$

The LP coefficients calculating unit 804 is configured to calculate the LP coefficients through the Levinson-Durbin algorithm according to the modified autocorrelation coefficients $r(0)'$ ... $r(k)'$ adjusted by the bandwidth expanding unit 803.

The CELP coding unit 805 is configured to input the LP coefficients calculated by the LP coefficients calculating unit 804 and the input signal into the CELP model to obtain a coded bit stream.

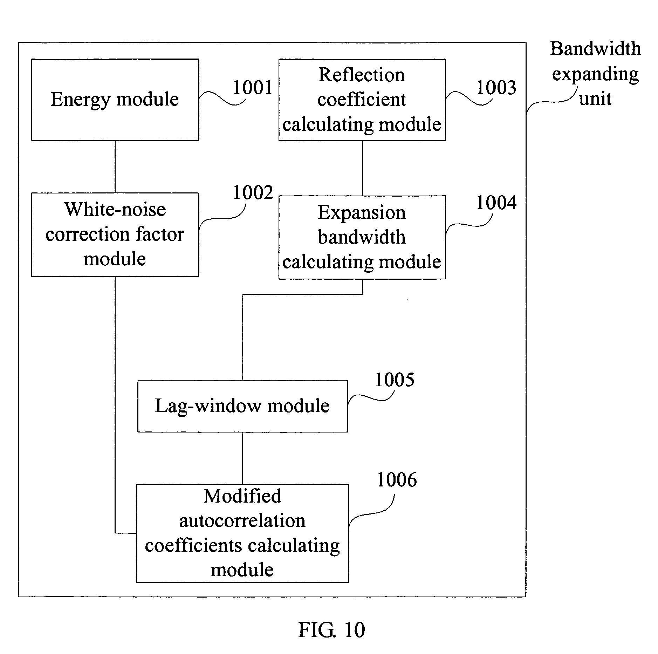

As shown in FIG. 10, the bandwidth expanding unit in another embodiment may include an energy module 1001, a white-noise correction factor module 1002, a reflection coefficient calculating module 1003, an expansion bandwidth calculating module 1004, a lag-window module 1005, and a modified autocorrelation coefficients calculating module 1006. The bandwidth expanding unit shown in FIG. 10 may be an alternative of the bandwidth expanding unit 603 in the sixth embodiment and the bandwidth expanding unit 803 in the seventh embodiment; the bandwidth expanding unit 603 may be applied in the seventh embodiment to replace the bandwidth expanding unit 803, and the bandwidth expanding unit 803 may be applied in the sixth embodiment to replace the bandwidth expanding unit 603.

The energy module 1001 is configured to calculate an energy parameter according to the original autocorrelation coefficients.

In some embodiments, the energy module 1001 may calculate the frame average energy according to the first coefficient $r(0)$ of the original autocorrelation coefficients.

*Ener_ avg = r(0)/ N*, where N is the frame length.

In other embodiments, the energy module 1001 may calculate the frame energy parameter *Ener* according to the first coefficient $r(0)$ of the original autocorrelation coefficients:

$$Ener = 30 - \lfloor \log_2[r(0)] \rfloor,$$

where $\lfloor x \rfloor$ refers to rounding down, namely, $\lfloor x \rfloor = \max\{n \in \{\ldots,-2,-1,0,1,2,\ldots\} \mid x \geq n\}$.

The white-noise correction factor module 1002 is configured to adjust the white-noise correction factor according to the energy parameter calculated by the energy module 1001.

In this embodiment, an energy threshold $E_{thr}$ may be set. According to the relationship between the energy parameter $E$ and the $E_{thr}$, the input signals are differentiated. Different adjustment functions are used to adjust the white-noise correction factor for different input signals. Specifically, different adjustment functions are used to adjust the white-noise correction factor according to different energy threshold intervals in which the energy parameter ranges:

$$win_{lag}(0) = \begin{cases} function\_1(r(0)); & E \in [0, E_{thr1}) \\ function\_2(r(0)); & E \in [E_{thr1}, E_{thr2}) \\ \vdots \\ function\_n(r(0)); & E \in [E_{thr(n-1)}, E_{thrn}] \end{cases}$$

In some embodiments, the white-noise correction factor module 1002 may categorize the frame signals into high-energy frame signals and low-energy frame signals according to the frame average energy $Ener\_avg$ and the energy threshold $E_{thr}$, and then adjust the white-noise correction factor $win_{lag}(0)$ accordingly:

$$if(Ener\_avg >= E_{thr})$$
$$win_{lag}(0) = H + \alpha * Ener\_avg;$$
$$else$$
$$win_{lag}(0) = L + \beta * Ener\_avg;$$

where $E_{thr}$, $H$, $L$, $\alpha$, $\beta$ are empirical constants, which may be obtained according to the specific conditions.

In other embodiments, the white-noise correction factor module 1002 may categorize the frame signals into high-energy frame signals and low-energy frame signals according to the frame energy parameter $Ener$ and the energy threshold $E_{thr}$, and then adjust the white-noise correction factor $win_{lag}(0)$ accordingly:

$$if(Ener < E_{thr})$$
$$win_{lag}(0) = L + \beta * (Ener + E_{thr});$$
$$else$$
$$win_{lag}(0) = H + \alpha * (Ener + E_{thr});$$

where $H$, $L$, $\alpha$, $\beta$ are empirical constants, which may be obtained according to the specific conditions.

The reflection coefficient calculating module 1003 is configured to calculate at least one reflection coefficient of the frame signal according to the original autocorrelation coefficients. In this embodiment, only the first reflection coefficient is calculated to simplify the calculation, but the present invention is not limited to calculate only the first reflection coefficient.

$$k_1 = \frac{r(1)}{r(0)}.$$

The expansion bandwidth calculating module 1004 is configured to adaptively calculate and adjust the expansion bandwidth according to the reflection coefficient $k_1$ calculated by the reflection coefficient calculating module 1003:

$f_0 = F + \alpha k_1$, where F may be 60 Hz, and $\alpha$ is an empirical factor which is determined experimentally.

The lag-window module 1005 is configured to calculate the lag-window according to the expansion bandwidth $f_0$ output by the expansion bandwidth calculating module 1004:

$$win_{lag}(k) = \exp\left[ -\frac{1}{2}\left( \frac{2\pi f_0 k}{f_s} \right)^2 \right] \qquad k = 1,\ldots,p$$

where $f_0$ is the expansion bandwidth calculated by the expansion bandwidth calculating module 1004; $f_s$ is a signal sampling frequency such as 8000 Hz; and $p$ is the order of LP.

The modified autocorrelation coefficients calculating module 1006 is configured to: according to the original autocorrelation coefficients $r(k)$, the white-noise correction factor $win_{lag}(0)$ and the lag-window $win_{lag}(k)$, calculate the modified autocorrelation coefficients after the autocorrelation coefficient correction factors are adjusted:

$$r(0)' = win_{lag}(0)r(0)$$

$$r(k)' = win_{lag}(k)r(k) \qquad k = 1,\ldots,p$$

With the technical solution in the foregoing embodiment, the energy parameter and the reflection coefficient that indicates the characteristics of the input signal are calculated through the original autocorrelation coefficients; according to the energy parameter, the white-noise correction factor is adjusted; according to the reflection coefficient, the expansion bandwidth is determined, and the lag-window is adjusted so that the adjusted autocorrelation coefficient correction factors are determined according to the characteristics of each frame signal. Therefore, the LP coefficients fit in with the characteristics of the signals more accurately; ill-conditioned cases are avoided; the calculated coefficients are more robust; and the calculation complexity is low.

In the embodiments of the present invention, the LP coefficients are calculated according to the modified autocorrelation coefficients through many algorithms such as the Levinson-Durbin algorithm, covariance method, and lattice method. The foregoing embodiments take the Levinson-Durbin algorithm as an example, but the present invention does not limit the algorithm.

In the embodiments of the present invention, multiple reflection coefficients $k_i$ of the windowed input signal may be calculated according to the original autocorrelation coefficients, and then the expansion bandwidth is calculated through one or more reflection coefficients. In this case, the calculation mode of the expansion bandwidth may change accordingly. That is, multiple reflection coefficients are used together with multiple regulating expansion factors to generate a new expression between the reflection coefficient and the expansion bandwidth. The embodiments of the present invention give an exemplary expression between the reflection coefficient and the expansion bandwidth, but those skilled in the art may derive various expressions between the reflection coefficient and the expansion bandwidth from the embodiments described herein without creative work. The present invention does not limit the expression between the reflection coefficient and the expansion bandwidth. Specifically, the regulating expansion factor corresponding to each reflection coefficient may be obtained through training by using representative training data, and the training is benchmarked against the final coder performance, and then various expressions between the reflection coefficient and the expansion bandwidth are constructed.

It is understandable to those skilled in the art that all or part of the steps of the foregoing embodiments may be implemented by hardware instructed by a computer program. The program may be stored in a computer-readable storage medium. When being executed, the program performs the processes covered in the foregoing embodiments. The storage medium may be a magnetic disk, a compact disk, a Read-Only Memory (ROM), or a Random Access Memory (RAM).

Detailed above are the objectives, technical solution and benefits of the embodiments of the present invention. Although the invention has been described through several exemplary embodiments, the invention is not limited to such embodiments. It is apparent that those skilled in the art can make modifications and variations to the invention without departing from the scope of the invention. The invention is intended to cover the modifications and variations provided that they fall in the scope of protection defined by the following claims.

**Claims**

1. An audio signal compression method, comprising:

   multiplying an input audio signal by a window function;
   calculating original autocorrelation coefficients of the windowed input audio signal;
   **characterized by** adjusting autocorrelation coefficient correction factors according to the original autocorrelation coefficients;
   calculating modified autocorrelation coefficients according to the original autocorrelation coefficients and the adjusted autocorrelation coefficient correction factors;
   calculating linear prediction coefficients according to the modified autocorrelation coefficients; and
   coding the input audio signal according to the linear prediction coefficients, and outputting a coded bit stream.

2. The signal compression method according to claim 1, wherein the adjusting autocorrelation coefficient correction factors according to the original autocorrelation coefficients comprises:

   calculating an energy parameter according to the original autocorrelation coefficients, and adjusting a white-noise correction factor according to the energy parameter; and
   calculating at least one reflection coefficient of the windowed input signal according to the original autocorrelation coefficients, adjusting an expansion bandwidth according to the at least one reflection coefficient, and calculating a lag-window according to an adjusted expansion bandwidth.

3. The signal compression method according to claim 1, wherein the adjusting autocorrelation coefficient correction factors according to the original autocorrelation coefficients comprises:

   calculating an energy parameter according to the original autocorrelation coefficients, and adjusting a white-noise correction factor according to the energy parameter; and
   calculating a lag-window according to an expansion bandwidth.

4. The signal compression method according to claim 2 or claim 3, wherein the calculating an energy parameter according to the original autocorrelation coefficients, and adjusting a white-noise correction factor according to the energy parameter comprises:

   calculating the energy parameter according to the first coefficient $r(0)$ of the original autocorrelation coefficients; and
   using different adjustment functions to adjust the white-noise correction factor according to different energy threshold intervals in which the energy parameter ranges, that is,

   $$win_{lag}(0) = \begin{cases} function\_1(r(0)); & E \in [0, E_{thr1}) \\ function\_2(r(0)); & E \in [E_{thr1}, E_{thr2}) \\ \vdots \\ function\_n(r(0)); & E \in [E_{thr(n-1)}, E_{thrn}] \end{cases},$$

   where $win_{lag}(0)$ is the white-noise correction factor, $E$ is the energy parameter, and $E_{thr}$ is the energy threshold.

5. The signal compression method according to claim 2 or claim 3, wherein the calculating an energy parameter according to the original autocorrelation coefficients, and adjusting a white-noise correction factor according to the energy parameter comprises:

   calculating a frame energy parameter $Ener$ according to the first coefficient $r(0)$ of the original autocorrelation coefficients through the formulation

$$Ener = 30 - \lfloor \log_2[r(0)] \rfloor;$$

and

adjusting the white-noise correction factor $win_{lag}$ (0) through the formulation $win_{lag}$ (0) = $H + \alpha * (Ener + E_{trh})$ if the frame energy parameter $Ener$ is greater than or equal to the energy threshold $E_{thr}$; adjusting the white-noise correction factor $win_{lag}$ (0) through the formulation $win_{lag}$ (0) = $L + \beta * (Ener + E_{thr})$ if the frame energy parameter $Ener$ is less than the energy threshold $E_{thr}$; where $H$, $L$, $\alpha$, $\beta$ are empirical constants.

6. The signal compression method according to claim 2 or claim 3, wherein the calculating an energy parameter according to the original autocorrelation coefficients, and adjusting a white-noise correction factor according to the energy parameter comprises:

calculating a frame average energy $Ener\_avg$ according to the first coefficient $r(0)$ of the original autocorrelation coefficients and a frame length $N$ through the formulation $Ener\_avg = r(0)/N$; and
adjusting the white-noise correction factor $win_{lag}$ (0) through the formulation $win_{lag}$ (0) = $H + \alpha * Ener\_avg$ if the frame average energy $Ener\_avg$ is greater than or equal to the energy threshold $E_{thr}$; adjusting the white-noise correction factor $win_{lag}$ (0) through the formulation $win_{lag}$ (0) = $L + \beta * Ener\_avg$ if the frame average energy $Ener\_avg$ is less than the energy threshold $E_{thr}$; where $H$, $L$, $\alpha$, $\beta$ are empirical constants.

7. The signal compression method according to claim 1, wherein the adjusting autocorrelation coefficient correction factors according to the original autocorrelation coefficients comprises:

calculating at least one reflection coefficient of the windowed input signal according to the original autocorrelation coefficients, adjusting an expansion bandwidth according to the at least one reflection coefficient, and calculating a lag-window according to an adjusted expansion bandwidth.

8. The signal compression method according to claim 2 or claim 7, wherein the calculating at least one reflection coefficient of the windowed input signal according to the original autocorrelation coefficients, adjusting an expansion bandwidth according to the at least one reflection coefficient comprises:

calculating the first reflection coefficient $k_1$ through the formulation $k_1 = {}^{r(1)}/_{r(0)}$, where $r(0)$ is the first coefficient of the original autocorrelation coefficients, $r(1)$ is the second coefficient of the original autocorrelation coefficients; and
calculating the expansion bandwidth $f_0$ through the formulation $f_0 = F + \alpha k_1$, where $F$ and $\alpha$ are empirical constants.

9. The signal compression method according to any one of claims 1 to 3, wherein the coding the input signal according to the linear prediction coefficients, and outputting a coded bit stream comprises:

performing linear prediction for the input signal according to the linear prediction coefficients, calculating a residual signal, coding the residual signal , and outputting the coded bit stream.

10. An audio signal compression apparatus, comprising:

a windowing unit (501), configured to multiply an input audio signal by a window function;
an original autocorrelation coefficients calculating unit (502), configured to calculate the original autocorrelation coefficients of the input audio signal processed by the windowing unit;
a bandwidth expanding unit **characterized by**, configured to adjust autocorrelation coefficient (503) correction factors according to the original autocorrelation coefficients calculated by the original autocorrelation coefficients calculating unit, and calculate modified autocorrelation coefficients according to the original autocorrelation coefficients and the adjusted autocorrelation coefficient correction factors;
a linear prediction coefficients calculating unit (504), configured to calculate the linear prediction coefficients according to the modified autocorrelation coefficients calculated by the bandwidth expanding unit; and
a compressing unit (505), configured to code the input audio signal according to the linear prediction coefficients calculated by the linear prediction coefficients calculating unit, and output a coded bit stream.

**11.** The signal compression apparatus according to claim 10, wherein the bandwidth expanding unit comprises:

an energy module, configured to calculate an energy parameter according to the original autocorrelation coefficients;
a white-noise correction factor module, configured to adjust the white-noise correction factor according to the energy parameter calculated by the energy module;
a reflection coefficient calculating module, configured to calculate at least one reflection coefficient of the windowed input signal according to the original autocorrelation coefficients;
an expansion bandwidth calculating module, configured to adjust the expansion bandwidth according to the at least one reflection coefficient calculated by the reflection coefficient calculating module;
a lag-window module, configured to calculate the lag-window according to an adjusted expansion bandwidth output by the expansion bandwidth calculating module; and
a modified autocorrelation coefficients calculating module, configured to calculate the modified autocorrelation coefficients according to the original autocorrelation coefficients, an adjusted white-noise correction factor, and the lag-window.

**12.** The signal compression apparatus according to claim 10, wherein the bandwidth expanding unit comprises:

an energy module, configured to calculate an energy parameter according to the original autocorrelation coefficients;
a white-noise correction factor module, configured to adjust the white-noise correction factor according to the energy parameter calculated by the energy module;
a lag-window module, configured to calculate the lag-window according to an expansion bandwidth; and
a modified autocorrelation coefficients calculating module, configured to calculate the modified autocorrelation coefficients according to the original autocorrelation coefficients, an adjusted white-noise correction factor, and the lag-window.

**13.** The signal compression apparatus according to claim 10, wherein the bandwidth expanding unit comprises:

a white-noise correction factor module, configured to determine the white-noise correction factor;
a reflection coefficient calculating module, configured to calculate at least one reflection coefficient of the windowed input signal according to the original autocorrelation coefficients;
an expansion bandwidth calculating module, configured to adjust the expansion bandwidth according to the at least one reflection coefficient calculated by the reflection coefficient calculating module;
a lag-window module, configured to calculate the lag-window according to an adjusted expansion bandwidth output by the expansion bandwidth calculating module; and
a modified autocorrelation coefficients calculating module, configured to calculate the modified autocorrelation coefficients according to the original autocorrelation coefficients, the white-noise correction factor, and the lag-window.

**14.** The signal compression apparatus according to any one of claims 10 to 13, further comprising:

a preprocessing unit, configured to preprocess the input signal for different types of compression, and send a preprocessed input signal to the windowing unit to make the input signal more suitable for being processed by subsequent modules.

**15.** A computer-readable medium having computer usable instructions stored thereon for execution by a processor to perform an audio signal compression, method, the method comprising:

multiplying an input audio signal by a window function; calculating original autocorrelation coefficients of the windowed input audio signal;
**characterized by** adjusting autocorrelation coefficient correction factors according to the original autocorrelation coefficients;
calculating modified autocorrelation coefficients according to the original autocorrelation coefficients and the adjusted autocorrelation coefficient correction factors;
calculating linear prediction coefficients according to the modified autocorrelation coefficients; and
coding the input audio signal according to the linear prediction coefficients, and outputting a coded bit stream.

**Patentansprüche**

1.  Audiosignal-Komprimierungsverfahren mit den folgenden Schritten:

    Multiplizieren eines Eingangsaudiosignals mit einer Fensterfunktion;
    Berechnen von ursprünglichen Autokorrelationskoeffizienten des gefensterten Eingangsaudiosignals;
    **gekennzeichnet durch**
    Justieren von Autokorrelationskoeffizienten-Korrekturfaktoren gemäß den ursprünglichen Autokorrelationskoeffizienten;
    Berechnen von modifizierten Autokorrelationskoeffizienten gemäß den ursprünglichen Autokorrelationskoeffizienten und den justierten Autokorrelationskoeffizienten-Korrekturfaktoren;
    Berechnen von Linearprädiktionskoeffizienten gemäß den modifizierten Autokorrelationskoeffizienten; und
    Codieren des Eingangsaudiosignals gemäß den Linearprädiktionskoeffizienten und Ausgeben eines codierten Bitstroms.

2.  Signalkomprimierungsverfahren nach Anspruch 1, wobei das Justieren von Autokorrelationskoeffizienten-Korrekturfaktoren gemäß den ursprünglichen Autokorrelationskoeffizienten Folgendes umfasst:

    Berechnen eines Energieparameters gemäß den ursprünglichen Autokorrelationskoeffizienten und Justieren eines Weißrauschen-Korrekturfaktors gemäß dem Energieparameter; und
    Berechnen mindestens eines Reflexionskoeffizienten des gefensterten Eingangssignals gemäß den ursprünglichen Autokorrelationskoeffizienten, Justieren einer Expansionsbandbreite gemäß dem mindestens einen Reflexionskoeffizienten und Berechnen eines Verzögerungsfensters gemäß einer justierten Expansionsbandbreite.

3.  Signalkomprimierungsverfahren nach Anspruch 1, wobei das Justieren von Autokorrelationskoeffizienten-Korrekturfaktoren gemäß den ursprünglichen Autokorrelationskoeffizienten Folgendes umfasst:

    Berechnen eines Energieparameters gemäß den ursprünglichen Autokorrelationskoeffizienten und Justieren eines Weißrauschen-Korrekturfaktors gemäß dem Energieparameter; und
    Berechnen eines Verzögerungsfensters gemäß einer Expansionsbandbreite.

4.  Signalkomprimierungsverfahren nach Anspruch 2 oder Anspruch 3, wobei das Berechnen eines Energieparameters gemäß den ursprünglichen Autokorrelationskoeffizienten und das Justieren eines Weißrauschen-Korrekturfaktors gemäß dem Energieparameter Folgendes umfasst:

    Berechnen des Energieparameters gemäß dem ersten Koeffizienten r(0) der ursprünglichen Autokorrelationskoeffizienten; und
    Verwenden verschiedener Justierungsfunktionen zum Justieren des Weißrauschen-Korrekturfaktors gemäß verschiedenen Energieschwellenintervallen, in denen der Energieparameter liegt, das heißt

$$win_{lag}(0) = \begin{cases} function\_1(r(0)); & E \in [0, E_{thr1}) \\ function\_2(r(0)); & E \in [E_{thr1}, E_{thr2}) \\ \vdots \\ function\_n(r(0)); & E \in [E_{thr(n-1)}, E_{thrn}] \end{cases} ,$$

    wobei $win_{lag}(0)$ der Weißrauschen-Korrekturfaktor, $E$ der Energieparameter und $E_{thr}$ die Energieschwelle ist.

5.  Signalkomprimierungsverfahren nach Anspruch 2 oder Anspruch 3, wobei das Berechnen eines Energieparameters gemäß den ursprünglichen Autokorrelationskoeffizienten und das Justieren eines Weißrauschen-Korrekturfaktors gemäß dem Energieparameter Folgendes umfasst:

Berechnen eines Rahmenenergieparameters *Ener* gemäß dem ersten Koeffizienten r(0) der ursprünglichen Autokorrelationskoeffizienten durch die Formulierung

$$Ener = 30 - \left\lfloor \log_2[r(0)] \right\rfloor;$$

und
Justieren des Weißrauschen-Korrekturfaktors $win_{lag}(0)$ durch die Formulierung $win_{lag}(0) = H + \alpha * (Ener + E_{thr})$, wenn der Rahmenenergieparameter *Ener* größer oder gleich der Energieschwelle $E_{thr}$ ist; Justieren des Weißrauschen-Korrekturfaktors $win_{lag}(0)$ durch die Formulierung $win_{lag}(0) = L + \beta * (Ener + E_{thr})$, wenn der Rahmenenergieparameter *Ener* kleiner als die Energieschwelle $E_{thr}$ ist; wobei $H, L, \alpha, \beta$ empirische Konstanten sind.

6. Signalkomprimierungsverfahren nach Anspruch 2 oder Anspruch 3, wobei das Berechnen eines Energieparameters gemäß den ursprünglichen Autokorrelationskoeffizienten und das Justieren eines Weißrauschen-Korrekturfaktors gemäß dem Energieparameter Folgendes umfasst:

Berechnen einer Rahmendurchschnittsenergie *Ener_avg* gemäß dem ersten Koeffizienten $r(0)$ der ursprünglichen Autokorrelationskoeffizienten und einer Rahmenlänge *N* durch die Formulierung $Ener\_avg = r(0)/N$; und Justieren des Weißrauschen-Korrekturfaktors $win_{lag}(0)$ durch die Formulierung $win_{lag}(0) = H + \alpha * Ener\_avg$, wenn die Rahmendurchschnittsenergie *Ener_ avg* größer oder gleich der Energieschwelle $E_{thr}$ ist; Justieren des Weißrauschen-Korrekturfaktors $win_{lag}(0)$ durch die Formulierung $win_{lag}(0) = L + \beta * Ener\_avg$, wenn die Rahmendurchschnittsenergie *Ener_avg* kleiner als die Energieschwelle $E_{thr}$ ist; wobei $H, L, \alpha, \beta$ empirische Konstanten sind.

7. Signalkomprimierungsverfahren nach Anspruch 1, wobei das Justieren von Autokorrelationskoeffizienten-Korrekturfaktoren gemäß den ursprünglichen Autokorrelationskoeffizienten Folgendes umfasst:

Berechnen mindestens eines Reflexionskoeffizienten des gefensterten Eingangssignals gemäß den ursprünglichen Autokorrelationskoeffizienten, Justieren einer Expansionsbandbreite gemäß dem mindestens einen Reflexionskoeffizienten und Berechnen eines Verzögerungsfensters gemäß einer justierten Expansionsbandbreite.

8. Signalkomprimierungsverfahren nach Anspruch 2 oder Anspruch 7, wobei das Berechnen mindestens eines Reflexionskoeffizienten des gefensterten Eingangssignals gemäß den ursprünglichen Autokorrelationskoeffizienten und das Justieren einer Expansionsbandbreite gemäß dem mindestens einen Reflexionskoeffizienten Folgendes umfasst:

Berechnen des ersten Reflexionskoeffizienten $k_1$ durch die Formulierung $k_1 = r(1)/r(0)$, wobei $r(0)$ der erste Koeffizient der ursprünglichen Autokorrelationskoeffizienten und $r(1)$ der zweite Koeffizient der ursprünglichen Autokorrelationskoeffizienten ist; und Berechnen der Expansionsbandbreite $f_0$ durch die Formulierung $f_0 = F + \alpha k_1$, wobei *F* und $\alpha$ empirische Konstanten sind.

9. Signalkomprimierungsverfahren nach einem der Ansprüche 1 bis 3, wobei das Codieren des Eingangssignals gemäß den Linearprädiktionskoeffizienten und das Ausgeben eines codierten Bitstroms Folgendes umfasst:

Ausführen von Linearprädiktion für das Eingangssignal gemäß den Linearprädiktionskoeffizienten, Berechnen eines Restsignals, Codieren des Restsignals und Ausgeben des codierten Bitstroms.

10. Audiosignal-Komprimierungsvorrichtung, umfassend:

eine Fensterbildungseinheit (501), die dafür ausgelegt ist, ein Eingangsaudiosignal mit einer Fensterfunktion zu multiplizieren;
eine Einheit (502) zum Berechnen von ursprünglichen Autokorrelationskoeffizienten, die dafür ausgelegt ist, die ursprünglichen Autokorrelationskoeffizienten des durch die Fensterbildungseinheit verarbeiteten Eingangsaudiosignals zu berechnen;

**gekennzeichnet durch**

eine Bandbreitenexpandiereinheit (503), die dafür ausgelegt ist, Autokorrelationskoeffizienten-Korrekturfaktoren gemäß den **durch** die Einheit zur Berechnung von ursprünglichen Autokorrelationskoeffizienten berechneten ursprünglichen Autokorrelationskoeffizienten zu justieren und modifizierte Autokorrelationskoeffizienten gemäß den ursprünglichen Autokorrelationskoeffizienten und den justierten Autokorrelationskoeffizienten-Korrekturfaktoren zu berechnen;

eine Linearprädiktionskoeffizienten-Berechnungseinheit (504), die dafür ausgelegt ist, die Linearprädiktionskoeffizienten gemäß den **durch** die Bandbreitenexpandiereinheit berechneten modifizierten Autokorrelationskoeffizienten zu berechnen; und

eine Komprimiereinheit (505), die dafür ausgelegt ist, das Eingangsaudiosignal gemäß den **durch** die Linearprädiktionskoeffizienten-Berechnungseinheit berechneten Linearprädiktionskoeffizienten zu codieren und einen codierten Bitstrom auszugeben.

11. Signalkomprimierungsvorrichtung nach Anspruch 10, wobei die Bandbreitenexpandiereinheit Folgendes umfasst:

ein Energiemodul, das dafür ausgelegt ist, einen Energieparameter gemäß den ursprünglichen Autokorrelationskoeffizienten zu berechnen;

ein Weißrauschen-Korrekturfaktormodul, das dafür ausgelegt ist, den Weißrauschen-Korrekturfaktor gemäß dem durch das Energiemodul berechneten Energieparameter zu justieren;

ein Reflexionskoeffizienten-Berechnungsmodul, das dafür ausgelegt ist, mindestens einen Reflexionskoeffizienten des gefensterten Eingangssignals gemäß den ursprünglichen Autokorrelationskoeffizienten zu berechnen;

ein Expansionsbandbreiten-Berechnungsmodul, das dafür ausgelegt ist, die Expansionsbandbreite gemäß dem durch das Reflexionskoeffizienten-Berechnungsmodul berechneten mindestens einen Reflexionskoeffizienten zu justieren;

ein Verzögerungsfenstermodul, das dafür ausgelegt ist, das Verzögerungsfenster gemäß einer durch das Expansionsbandbreiten-Berechnungsmodul ausgegebenen justierten Expansionsbandbreite zu berechnen; und

ein Modul zum Berechnen modifizierter Autokorrelationskoeffizienten, das dafür ausgelegt ist, die modifizierten Autokorrelationskoeffizienten gemäß den ursprünglichen Autokorrelationskoeffizienten, einem justierten Weißrauschen-Korrekturfaktor und dem Verzögerungsfenster zu berechnen.

12. Signalkomprimierungsvorrichtung nach Anspruch 10, wobei die Bandbreitenexpandiereinheit Folgendes umfasst:

ein Energiemodul, das dafür ausgelegt ist, einen Energieparameter gemäß den ursprünglichen Autokorrelationskoeffizienten zu berechnen;

ein Weißrauschen-Korrekturfaktormodul, das dafür ausgelegt ist, den Weißrauschen-Korrekturfaktor gemäß dem durch das Energiemodul berechneten Energieparameter zu justieren;

ein Verzögerungsfenstermodul, das dafür ausgelegt ist, das Verzögerungsfenster gemäß einer Expansionsbandbreite zu berechnen; und

ein Modul zum Berechnen modifizierter Autokorrelationskoeffizienten, das dafür ausgelegt ist, die modifizierten Autokorrelationskoeffizienten gemäß den ursprünglichen Autokorrelationskoeffizienten, einem justierten Weißrauschen-Korrekturfaktor und dem Verzögerungsfenster zu berechnen.

13. Signalkomprimierungsvorrichtung nach Anspruch 10, wobei die Bandbreitenexpandiereinheit Folgendes umfasst:

ein Weißrauschen-Korrekturfaktormodul, das dafür ausgelegt ist, den Weißrauschen-Korrekturfaktor zu bestimmen;

ein Reflexionskoeffizienten-Berechnungsmodul, das dafür ausgelegt ist, mindestens einen Reflexionskoeffizienten des gefensterten Eingangssignals gemäß den ursprünglichen Autokorrelationskoeffizienten zu berechnen;

ein Expansionsbandbreiten-Berechnungsmodul, das dafür ausgelegt ist, die Expansionsbandbreite gemäß dem durch das Reflexionskoeffizienten-Berechnungsmodul berechneten mindestens einen Reflexionskoeffizienten zu justieren;

ein Verzögerungsfenstermodul, das dafür ausgelegt ist, das Verzögerungsfenster gemäß einer durch das Expansionsbandbreiten-Berechnungsmodul ausgegebenen justierten Expansionsbandbreite zu berechnen; und

ein Modul zum Berechnen modifizierter Autokorrelationskoeffizienten, das dafür ausgelegt ist, die modifizierten Autokorrelationskoeffizienten gemäß den ursprünglichen Autokorrelationskoeffizienten, dem Weißrauschen-Korrekturfaktor und dem Verzögerungsfenster zu berechnen.

14. Signalkomprimierungsvorrichtung nach einem der Ansprüche 10 bis 13, ferner umfassend:

eine Vorverarbeitungseinheit, die dafür ausgelegt ist, das Eingangssignal für verschiedene Arten von Komprimierung vorzuverarbeiten und ein vorverarbeitetes Eingangssignal zu der Fensterbildungseinheit zu senden, damit das Eingangssignal für die Verarbeitung durch nachfolgende Module besser geeignet ist.

15. Computerlesbares Medium, das darauf gespeicherte computerbenutzbare Anweisungen zur Ausführung durch einen Prozessor zum Ausführen eines Audiosignal-Komprimierungsverfahrens aufweist, wobei das Verfahren die folgenden Schritte umfasst:

Multiplizieren eines Eingangsaudiosignals mit einer Fensterfunktion;
Berechnen von ursprünglichen Autokorrelationskoeffizienten des gefensterten Eingangsaudiosignals;
**gekennzeichnet durch**
Justieren von Autokorrelationskoeffizienten-Korrekturfaktoren gemäß den ursprünglichen Autokorrelationskoeffizienten;
Berechnen von modifizierten Autokorrelationskoeffizienten gemäß den ursprünglichen Autokorrelationskoeffizienten und den justierten Autokorrelationskoeffizienten-Korrekturfaktoren;
Berechnen von Linearprädiktionskoeffizienten gemäß den modifizierten Autokorrelationskoeffizienten; und
Codieren des Eingangsaudiosignals gemäß den Linearprädiktionskoeffizienten und Ausgeben eines codierten Bitstroms.

## Revendications

1. Procédé de compression de signal audio, comprenant :

la multiplication d'un signal audio d'entrée par une fonction de fenêtrage ;
le calcul de coefficients d'autocorrélation d'origine du signal audio d'entrée fenêtré ;
**caractérisé par**
l'ajustement de facteurs de correction de coefficients d'autocorrélation en fonction des coefficients d'autocorrélation d'origine ;
le calcul de coefficients d'autocorrélation modifiés en fonction des coefficients d'autocorrélation d'origine et des facteurs de correction de coefficients d'autocorrélation ajustés ;
le calcul de coefficients de prédiction linéaire en fonction des coefficients d'autocorrélation modifiés ; et
le codage du signal audio d'entrée en fonction des coefficients de prédiction linéaire, et la production en sortie d'un train binaire codé.

2. Procédé de compression de signal selon la revendication 1, dans lequel l'ajustement des facteurs de correction de coefficients d'autocorrélation en fonction des coefficients d'autocorrélation d'origine comprend :

le calcul d'un paramètre d'énergie en fonction des coefficients d'autocorrélation d'origine, et l'ajustement d'un facteur de correction de bruit blanc en fonction du paramètre d'énergie ; et
le calcul d'au moins un coefficient de réflexion du signal d'entrée fenêtre en fonction des coefficients d'autocorrélation d'origine, l'ajustement d'une largeur de bande d'expansion en fonction de l'au moins un coefficient de réflexion, et le calcul d'une fenêtre de retard en fonction d'une largeur de bande d'expansion ajustée.

3. Procédé de compression de signal selon la revendication 1, dans lequel l'ajustement de facteurs de correction de coefficients d'autocorrélation en fonction des coefficients d'autocorrélation d'origine comprend :

le calcul d'un paramètre d'énergie en fonction des coefficients d'autocorrélation d'origine, et l'ajustement d'un facteur de correction de bruit blanc en fonction du paramètre d'énergie ; et
le calcul d'une fenêtre de retard en fonction d'une largeur de bande d'expansion.

4. Procédé de compression de signal selon la revendication 2 ou 3, dans lequel le calcul d'un paramètre d'énergie en fonction des coefficients d'autocorrélation d'origine, et l'ajustement d'un facteur de correction de bruit blanc en fonction du paramètre d'énergie comprennent :

le calcul du paramètre d'énergie en fonction du premier coefficient r(0) des coefficients d'autocorrélation d'origine ; et

l'utilisation de fonctions d'ajustement différentes pour ajuster le facteur de correction de bruit blanc en fonction de différents intervalles de seuil d'énergie dans lesquels est compris le paramètre d'énergie, autrement dit

$$win_{lag}(0) = \begin{cases} function\_1(r(0)); & E \in [0, E_{thr1}) \\ function\_2(r(0)); & E \in [E_{thr1}, E_{thr2}) \\ \vdots \\ function\_n(r(0)); & E \in [E_{thr(n-1)}, E_{thrn}] \end{cases},$$

où $win_{lag}(0)$ est le facteur de correction de bruit blanc, E est le paramètre d'énergie, et $E_{thr}$ est le seuil d'énergie.

5. Procédé de compression de signal selon la revendication 2 ou 3, dans lequel le calcul d'un paramètre d'énergie en fonction des coefficients d'autocorrélation d'origine, et l'ajustement d'un facteur de correction de bruit blanc en fonction du paramètre d'énergie comprennent :

le calcul d'un paramètre d'énergie de trame *Ener* en fonction du premier coefficient $r(0)$ des coefficients d'autocorrélation d'origine par la formulation $Ener = 30 - \lfloor \log_{2[} [r(0)] \rfloor$ ; et

l'ajustement du facteur de correction de bruit blanc $win_{lag}(0)$ par la formulation $win_{lag}(0) = H + \alpha * (Ener + E_{thr})$ si le paramètre d'énergie de trame *Ener* est supérieur ou égal au seuil d'énergie $E_{thr}$ ; l'ajustement du facteur de correction de bruit blanc $win_{lag}(0)$ par la formulation $win_{lag}(0) = L + \beta * (Ener + E_{thr})$ si le paramètre d'énergie de trame *Ener* est inférieur au seuil d'énergie $E_{thr}$ ; où $H$, $L$, $\alpha$, $\beta$ sont des constantes empiriques.

6. Procédé de compression de signal selon la revendication 2 ou 3, dans lequel le calcul d'un paramètre d'énergie en fonction des coefficients d'autocorrélation d'origine, et l'ajustement d'un facteur de correction de bruit blanc en fonction du paramètre d'énergie comprennent :

le calcul d'une énergie moyenne de trame *Ener_avg* en fonction du premier coefficient $r(0)$ des coefficients d'autocorrélation d'origine et d'une longueur de trame $N$ par la formulation $Ener\_avg = r(0)/N$ ; et

l'ajustement du facteur de correction de bruit blanc $win_{lag}(0)$ par la formulation $win_{lag}(0) = H + \alpha * Ener\_avg$ si l'énergie moyenne de trame *Ener_avg* est supérieure ou égale au seuil d'énergie $E_{thr}$ ; l'ajustement du facteur de correction de bruit blanc $win_{lag}(0)$ par la formulation $win_{lag}(0) = L + \beta * Ener\text{-}avg$ si l'énergie moyenne de trame est inférieure au seuil d'énergie $E_{thy}$ ; où $H$, $L$, $\alpha$, $\beta$ sont des constantes empiriques.

7. Procédé de compression de signal selon la revendication 1, dans lequel l'ajustement de facteurs de correction de coefficient d'autocorrélation en fonction des coefficients d'autocorrélation d'origine comprend :

le calcul d'au moins un coefficient de réflexion du signal d'entrée fenêtré en fonction des coefficients d'autocorrélation d'origine, l'ajustement d'une largeur de bande d'expansion en fonction de l'au moins un coefficient de réflexion, et le calcul d'une fenêtre de retard en fonction d'une largeur de bande d'expansion ajustée.

8. Procédé de compression de signal selon la revendication 2 ou la revendication 7, dans lequel le calcul d'au moins un coefficient de réflexion du signal d'entrée fenêtré en fonction des coefficients d'autocorrélation d'origine, l'ajustement d'une largeur de bande d'expansion en fonction de l'au moins un coefficient de réflexion comprennent :

le calcul du premier coefficient de réflexion $k_1$ par la formulation $k_1 = \dfrac{\tilde{r(1)}}{r(0)}$, où r(0) est le premier coefficient des coefficients d'autocorrélation d'origine, $r(1)$ est le second coefficient des coefficients d'autocorrélation d'origine ; et

le calcul de la largeur de bande d'expansion $f_o$ par la formulation $f_o = F + \alpha k_1$, où $F$ et $\alpha$ sont des constantes

empiriques.

9. Procédé de compression de signal selon l'une quelconque des revendications 1 à 3, dans lequel le codage du signal d'entrée en fonction des coefficients de prédiction linéaire, et la production en sortie d'un train binaire codé comprennent :

l'exécution d'une prédiction linéaire du signal d'entrée en fonction des coefficients de prédiction linéaire, le calcul d'un signal résiduel, le codage du signal résiduel, et la production en sortie du train binaire codé.

10. Appareil compression de signal audio, comprenant :

une unité de fenêtrage (501), configurée pour multiplier un signal audio d'entrée par une fonction de fenêtrage ;
une unité de calcul de coefficients d'autocorrélation d'origine (502), configurée pour calculer les coefficients d'autocorrélation d'origine du signal audio d'entrée traité par l'unité de fenêtrage ;
**caractérisé par**
une unité d'expansion de largeur de bande (503), configurée pour ajuster des facteurs de correction de coefficients d'autocorrélation en fonction des coefficients d'autocorrélation d'origine calculés par l'unité de calcul de coefficients d'autocorrélation d'origine, et calculer des coefficients d'autocorrélation modifiés en fonction des coefficients d'autocorrélation d'origine et des facteurs de correction de coefficients d'autocorrélation ajustés ;
une unité de calcul de coefficients de prédiction linéaire (504), configurée pour calculer les coefficients de prédiction linéaire en fonction des coefficients d'autocorrélation modifiés calculés par l'unité d'expansion de largeur de bande ; et
une unité de compression (505), configurée pour coder le signal audio d'entrée en fonction des coefficients de prédiction linéaire calculés par l'unité de calcul de coefficients de prédiction linéaire, et produire en sortie un train binaire codé.

11. Appareil de compression de signal selon la revendication 10, dans lequel l'unité d'expansion de largeur de bande comprend :

un module d'énergie, configuré pour calculer un paramètre d'énergie en fonction des coefficients d'autocorrélation d'origine ;
un module de facteur de correction de bruit blanc, configuré pour ajuster le facteur de correction de bruit blanc en fonction du paramètre d'énergie calculé par le module d'énergie ;
un module de calcul de coefficient de réflexion, configuré pour calculer au moins un coefficient de réflexion du signal d'entrée fenêtré en fonction des coefficients d'autocorrélation d'origine ;
un module de calcul de largeur de bande, configuré pour ajuster la largeur de bande d'expansion en fonction de l'au moins un coefficient de réflexion calculé par le module de calcul de coefficient de réflexion ;
un module de fenêtre de retard, configuré pour calculer la fenêtre de retard en fonction d'une largeur de bande d'expansion ajustée produite en sortie par le module de calcul de largeur de bande d'expansion ; et
un module de calcul de coefficients d'autocorrélation modifiés, configuré pour calculer les coefficients d'autocorrélation modifiés en fonction des coefficients d'autocorrélation d'origine, d'un facteur de bruit blanc ajusté et de la fenêtre de retard.

12. Appareil de compression de signal selon la revendication 10, dans lequel l'unité d'expansion de largeur de bande comprend :

un module d'énergie, configuré pour calculer un paramètre d'énergie en fonction des coefficients d'autocorrélation d'origine ;
un module de facteur de correction de bruit blanc, configuré pour ajuster un facteur de correction de bruit blanc en fonction du paramètre d'énergie calculé par le module d'énergie ;
un module de fenêtre de retard, configuré pour calculer la fenêtre de retard en fonction d'une largeur de bande d'expansion ; et
un module de calcul de coefficients d'autocorrélation modifiés, configuré pour calculer les coefficients d'autocorrélation modifiés en fonction des coefficients d'autocorrélation d'origine, d'un facteur de bruit blanc ajusté et de la fenêtre de retard.

13. Appareil de compression de signal selon la revendication 10, dans lequel l'unité d'expansion de largeur de bande comprend :

un module de facteur de correction de bruit blanc, configuré pour déterminer le facteur de correction de bruit blanc ;

un module de calcul de coefficient de réflexion, configuré pour calculer au moins un coefficient de réflexion du signal d'entrée fenêtré en fonction des coefficients d'autocorrélation d'origine ;

un module de calcul de largeur de bande d'expansion, configuré pour ajuster la largeur de bande d'expansion en fonction de l'au moins un coefficient de réflexion calculé par le module de calcul de coefficient de réflexion ;

un module de fenêtre de retard, configuré pour calculer la fenêtre de retard en fonction d'une largeur de bande d'expansion ajustée produite en sortie par le module de calcul de largeur de bande d'expansion ; et

un module de calcul de coefficients d'autocorrélation modifiés, configuré pour calculer les coefficients d'autocorrélation modifiés en fonction des coefficients d'autocorrélation d'origine, d'un facteur de bruit blanc ajusté et de la fenêtre de retard.

**14.** Appareil de compression de signal selon l'une quelconque des revendications 10 à 13, comprenant en outre :

une unité de prétraitement, configurée pour prétraiter le signal d'entrée pour différents types de compression, et envoyer un signal d'entrée prétraité à l'unité de fenêtrage en vue de faciliter le traitement du signal d'entrée par des modules ultérieurs.

**15.** Support lisible par ordinateur ayant en mémoire des instructions exécutables par ordinateur destinées à être exécutées par un processeur en vue d'exécuter un procédé de compression de signal audio, le procédé comprenant :

la multiplication d'un signal audio d'entrée par une fonction de fenêtrage ;

le calcul de coefficients d'autocorrélation d'origine du signal audio d'entrée fenêtré ;

**caractérisé par**

l'ajustement de facteurs de correction de coefficient d'autocorrélation en fonction des coefficients d'autocorrélation d'origine ;

le calcul des coefficients d'autocorrélation modifiés en fonction des coefficients d'autocorrélation d'origine et des facteurs de correction de coefficients d'autocorrélation modifiés ;

le calcul de coefficients de prédiction linéaire en fonction des coefficients d'autocorrélation ajustés ; et

le codage du signal audio d'entrée en fonction des coefficients de prédiction linéaire, et la production en sortie d'un train binaire codé.

Multiply an input signal by a window function — 101

Calculate original autocorrelation coefficients of a windowed input signal — 102

Adjust autocorrelation coefficient correction factors according to the original autocorrelation coefficients — 103

Calculate modified autocorrelation coefficients according to the original autocorrelation coefficients and the adjusted autocorrelation coefficient correction factors — 104

Calculate LP coefficients according to the modified autocorrelation coefficients — 105

Code the input signal according to the LP coefficients, and output a coded bit stream — 106

FIG. 1

Multiply an input signal by a window function — 201

Calculate original autocorrelation coefficients — 202

Calculate an energy parameter — 203

Adjust a white-noise correction factor according to the energy parameter — 204

Calculate a lag-window — 205

Calculate the modified autocorrelation coefficients according to the original autocorrelation coefficients, an adjusted white-noise correction factor, and the lag-window — 206

Calculate LP coefficients — 207

Output a coded bit stream — 208

FIG. 2

```
┌─────────────────────────────────┐
│ Multiply an input signal by a window │ ⟋301
│           function                │
└─────────────────────────────────┘
               │
               ▼
┌─────────────────────────────────┐
│      Calculate the original       │ ⟋302
│   autocorrelation coefficients    │
└─────────────────────────────────┘
               │
               ▼
┌─────────────────────────────────┐
│      Determine a white-noise       │ ⟋303
│        correction factor           │
└─────────────────────────────────┘
               │
               ▼
┌─────────────────────────────────┐
│   Calculate at least one reflection │ ⟋304
│    coefficient of the frame signal  │
└─────────────────────────────────┘
               │
               ▼
┌─────────────────────────────────┐
│    Adjust an expansion bandwidth   │ ⟋305
│  according to the reflection coefficient │
└─────────────────────────────────┘
               │
               ▼
┌─────────────────────────────────┐
│ Calculate a lag-window according to the │ ⟋306
│        expansion bandwidth         │
└─────────────────────────────────┘
               │
               ▼
┌─────────────────────────────────┐
│ Calculate modified autocorrelation coefficients │ 307
│   according to the original autocorrelation      │
│ coefficients, the white-noise correction factor, │
│            and the lag-window                   │
└─────────────────────────────────┘
               │
               ▼
┌─────────────────────────────────┐
│        Calculate LP coefficients   │ ⟋308
└─────────────────────────────────┘
               │
               ▼
┌─────────────────────────────────┐
│       Output a coded bit stream    │ ⟋309
└─────────────────────────────────┘
```

FIG. 3

FIG. 4

EP 2 204 797 B1

Signal characteristic
parameter

500

Preprocessing
unit

501

Windowing
unit

502

Original
autocorrelation
coefficients
calculating unit

503

Bandwidth
expanding unit

504

LP coefficients
calculating
unit

Input
signal

505

Compressing
unit

Output
signal

FIG. 5

Energy parameter

FIG. 6

603

701

Energy module

702

White-noise correction
factor module

703

Lag-window module

704

Modified
autocorrelation
coefficients
calculating module

FIG. 7

FIG. 8

EP 2 204 797 B1

803

White-noise correction
factor module — 901

Reflection coefficient
calculating module — 902

Expansion bandwidth
calculating module — 903

Lag-window module — 904

Modified
autocorrelation
coefficients calculating
module — 905

FIG. 9

Bandwidth
expanding
unit

| Energy module | 1001 | Reflection coefficient calculating module | 1003 |

| White-noise correction factor module | 1002 | Expansion bandwidth calculating module | 1004 |

Lag-window module — 1005

Modified autocorrelation coefficients calculating module — 1006

FIG. 10